# EUROPEAN PATENT SPECIFICATION

(11) **EP 1 972 997 B1**
(45) Date of publication and mention of the grant of the patent: **04.07.2012**
(21) Application number: 08102544.7
(22) Date of filing: 12.03.2008
(51) Int. Cl.: G03F 7/00, G03F 7/24

(54) **Nano-imprinting apparatus and method**
Nanoimprint-Vorrichtung und Verfahren
Appareil et procédé de nano-impression

(30) Priority: 19.03.2007 US 907053 P; 13.06.2007 US 808890
(43) Date of publication of application: 24.09.2008
(73) Proprietor: Obducat AB, 201 25 Malmö (SE)
(72) Inventor: Heidari, Babak, 244 65, Furulund (SE)
(74) Representative: Aurell, Henrik

(56) References cited:
- EP-A- 0 796 716
- EP-A- 1 473 594
- WO-A-99/58327
- WO-A-03/086743
- US-A- 5 634 606
- US-A1- 2004 255 804
- US-A1- 2006 027 949

## Description

### Technical Field of the Invention

The present invention relates in general to lithography and, more particularly, to an apparatus and a method in connection with the lithography of structures on a micro or nanometer scale. In particular, the invention relates to nano-imprint lithography on large area substrates or objects.

### Description of Related Art

The trend in microelectronics is towards ever smaller dimensions. Commercial components are now manufactured with structures of less than one micrometer in size, but there is a need to go even further down in dimensions, to < 100 nm. Research concerning nano-components has raised a demand for a commercially applicable manufacturing technique for components with dimensions of < 10 nm.

Some of the most interesting techniques for fabrication of micro and nanometer structures include different types of lithography. One of the most promising techniques for reproducing nanostructures - i.e. structures in the order of 100 nm or smaller - is the nano-imprint lithography (NIL) technology. The nanoimprint lithography (NIL) technology, e.g. as described in US Patent No. 5,772,905, has set out the basic preconditions for the mass production of structures close to atomic scale, see e.g. Stephen Y Chou, Peter R. Krauss, Wei Zhang, Lingjie Guo and Lei Zhuang : "Sub- 10nm imprint lithography and application", J. Vac. Sci. Technol. B, Vol. 15, No. 6, (1997*).* Several research reports have been presented on the subject, but hitherto the NIL technology has been restricted to nano-imprinting on components with a small total area, typically only a few square centimeters, see e.g. Stephen Y Chou, Peter R. Krauss and Preston J.Renstorm : "Nanoimprint lithography", J. Vac. Sci. Technol. B, 14, 4129 <RTI (1996*) ;* K. Pfeiffer, G. Bleidiessel, G. Gruetzner, H. Schulz, T. Hoffmann, H.-C. Scheer, C.M. Sotomayor Torres andJ. Ahopelto : "Suitability of new polymer materials with adjustable glasstemperature for nanoimprinting", Proceeding of Micro-and Nano-Engineering Conference, (1998*) ; and* Leuven. Bo Cui, Wei Wu, Linshu Kong, Xiaoyun Sun andstephen Y Chou : "Perpendicular quantized magnetic disks with 45 Gbits on a 4x4 cm2area"; J.Appl. Phys. 85, 5534(1999*).*

In a prior art nano-imprint lithography process, a substrate to be patterned is covered by a moldable layer. A pattern to be transferred to the substrate is predefined in three dimensions on a stamp or template. The stamp is brought into contact with the moldable layer, and the layer is softened, preferably by heating. The stamp is then moved by means of a vertical movement towards the softened layer such that the stamp is pressed into the softened layer, thereby making an imprint of the stamp pattern in the moldable layer. The layer is cooled down until it hardens to a satisfactory degree followed by detachment and removal of the stamp. Subsequent etching may be employed to replicate the stamp pattern in the substrate. Although this nano-imprinting process may be capable of mass production, it has hitherto been restricted to nano-imprinting on components with a small total area, typically only a few square centimeters.

A different form of nano-imprint lithography technology is commonly known as step and flash imprint lithography. The international patent application WO 02/067055 discloses a system for applying step and flash imprint lithography. Among other things, this document relates to production-scale implementation of a step and flash apparatus, also called a stepper. The template used in such an apparatus has a rigid body of transparent material, typically quartz. The template is supported in the stepper by flexure members, which allow the template to pivot about X and Y axes, which are mutually perpendicular in a plane parallel to the substrate surface to be imprinted. This mechanism also involves a piezo actuator for controlling parallelism and the gap between the template and the substrate. This system is, however, not capable of handling large area substrates in a single imprint step. A step and flash system offered on the marketplace is the IMPRIO 100, provided by Molecular Imprints, Inc., 1807-C West Braker Lane, Austin, TX 78758, U.S.A. This system has a template image area of about 25mm x 25 mm. Altough this system is capable of handling substrate wafers of up to 8 inches, the imprint process has to be repeated by lifting the template, moving it sideways, and lowering it to the substrate again, by means of a X-Y translation stage. Thus, this process is relatively time-consuming and, hence, also less optimum for large-scale production purposes. Further, this imprint process suffers from the drawback that continuous structures which are larger than said template size cannot be produced. All in all, this means that production costs may be too high to make this technique interesting for large-scale production of fine structure devices, especially on large area substrates or objects.

Some prior art solutions in the field of embossing of large area substrates are described below.

EP-A-1 473 594 discloses in one embodiment an apparatus that deals with transfer of a pattern from an optically transparent stamp onto a flexible substrate covered with a photopolymer. The stamp comprises an embossing drum while the flexible substrate is transported past the embossing drum. When the stamp is brought into contact with a part of the flexible substrate, ultraviolet light is used to irradiate the contacted portion of the photopolymer on the substrate and to achieve hardening.

EP-A-0 796 716 discloses a method for manufacturing a thermoplastic resin sheet carrying with an embossed pattern formed on one of its sides, while it carries and metal belt on the other. The thermoplastic resin sheet is transported between three rotating rolls, of which at least one has an imprint surface.

WO 99/58327 A deals with an apparatus for micro-embossing of optical features onto an optical disc. Once these features are transferred onto the disc, a metallic layer is placed on top of them. The apparatus in WO 99/58327 requires vacuum in order to operate properly and the substrate surface needs to be pre-treated prior to embossing by means of a stamp.

WO 03/086743 A describes a device for joining at least two layers forming a multiplayer web product, where two rolls rotating in opposite directions are in close contact with the sheet material to be formed and between which the sheet passes. One of the rolls comprises an imprint surface.

US 2004/255804 A1 describes a mounting cylinder where it is easy to replace one embossing tool with another embossing tool, in particular with a different diameter. The pressurized air inside a mounting shell is blown into the embossing tool which is to be put onto the mounting shell for better contact between the two. Thus the pressurized air inside the mounting shell is used to ease the putting on and the removal of the embossing tool from the mounting shell.

### Summary of the Invention

With the above and the following description in mind, then, an aspect of the present invention is to provide a nano-imprinting apparatus and method, which seek to mitigate, alleviate or eliminate one or more of the above-identified deficiencies in the art and disadvantages singly or in any combination.

A general object of some embodiments of the present invention is to provide a nano-imprinting apparatus and method for improving fabrication of structures comprising three-dimensional features on a micro or nanometer scale. In particular, it is an object of some embodiments of the invention to provide improved nano-imprinting apparatuses and methods for transferring a pattern of such structures to substrates having widths of more than one inch, and even for widths of 8 inches, widths of 12 inches, and larger. In particular, some embodiments of the apparatus and method have been developed for nano-imprinting of structures on substrates, which substrates have large total areas, normally rectangular-shaped areas, which are greater than approximately 7-20 *cm².* Moreover, some embodiments of the apparatus and method have been developed for nano-imprinting of structures on continuous substrates, which substrates have large total areas, especially significantly large total areas.

According to a first aspect of the invention, a nano-imprinting apparatus comprises elements as defined in claim 1.

In one embodiment, at least one of the first and the second roller is arranged to apply a pressure against the other roller when said rollers rotate with respect to each other.

In one embodiment, the mentioned pressure is within the range of 1-100 bar positive pressure, preferably within the range of 10-40 bar positive pressure.

In one embodiment, the nano-imprinting apparatus further comprises means for adjusting the pressure of said medium to a pressure within a range of 1-100 bar positive pressure, preferably within a range of 10-40 bar.

In one embodiment, the membrane is made of a flexible material, preferably a polymer material or a thin metal, even more preferably a plastic, a rubber or a thin metal, the membrane having a thickness of up to 10 mm, preferably up to 3 mm or even more preferably up to 1 mm.

In one embodiment, the medium comprises a gas.

In a preferred embodiment, said medium comprises air.

In one embodiment, the first rotatably mounted roller has a diameter of up to 5 m, preferably up to 2 m, and even more preferably up to 1 m.

In one embodiment, the first rotatably mounted roller has a length of up to 2,5 m, preferably up to 1.5 m, and even more preferably up to 1 m.

In one embodiment, the ratio between the diameter and the length of the first rotatably mounted roller is 1:2.

In one embodiment, the second rotatably mounted roller has a diameter of up to 5 m, preferably up to 2 m, and even more preferably up to 1 m.

In one embodiment, the second rotatably mounted roller has a length of up to 2,5 m, preferably up to 1.5 m, and even more preferably up to 1 m.

In one embodiment, the ratio between the diameter and the length of the second rotatably mounted roller is 1:2.

In a preferred embodiment, the nano-imprinting apparatus further comprises a heating means for heating the substrate, wherein the heating means is positioned to heat the substrate before said substrate moves between said first and second rollers.

In one embodiment, the heating means is a heating chamber positioned such that the substrate is moveable through said heating chamber such that, during operation, heating of the substrate is performed before said substrate moves between said first and second rollers.

In one embodiment, the heating means comprises at least one further rotatably mounted roller with a principally plane circumferential and heated surface positioned such that the substrate is moveable onto said heated surface such that, during operation, heating of the substrate is performed via said heated surface before said substrate moves between said first and second rollers.

In a preferred embodiment, the nano-imprinting apparatus further comprises a cooling means for cooling the substrate, wherein the cooling means is positioned to cool the substrate after said substrate has passed between said first and second rollers.

In one embodiment, the cooling means is a cooling chamber positioned such that the substrate is moveable through said cooling chamber such that, during operation, cooling of the substrate is performed after said substrate has passed between said first and second rollers.

In one embodiment, the cooling means comprises at least one further rotatably mounted roller with a principally plane circumferential and cooling surface positioned such that the substrate is moveable onto said cooling surface such that, during operation, cooling of the substrate is performed via said cooling surface after said substrate has moved between said first and second rollers.

In one embodiment, the substrate is a continuous substrate.

In a preferred embodiment, the substrate is a foil or a thin film.

According to another aspect of the invention, a nano-imprinting method is performed as defined in claim 22.

In one embodiment, the method further comprises:
applying a pressure against either of or both of said rollers when said rollers rotate with respect to each other.

In one embodiment, the medium comprises a gas.

In a preferred embodiment, the medium comprises air.

In one embodiment, the method further comprises:
heating the substrate before said substrate moves between said first and second rollers.

In one embodiment, the method further comprises:
cooling the substrate after said substrate has passed between said first and second rollers.

In one embodiment, the substrate is a continuous substrate.

In a preferred embodiment, the substrate is a foil or a thin film.

According to a third aspect, there is provided a nano-imprinting apparatus as disclosed in this specification and in the accompanying drawings.

### Brief Description of the Drawings

Further objects, features and advantages of the invention will appear from the following detailed description of embodiments of the invention, wherein embodiments of the invention will be described in more detail with reference to the accompanying drawings, in which:
Fig. 1 is a cross-sectional side view of a nano-imprinting apparatus in accordance with an embodiment of the invention;
Fig. 2 is different view of the nano-imprinting apparatus shown in Fig. 1;
Fig. 3 is a cross-sectional side view, on a micro or nano-level, illustrating when a first roller, a second roller and a substrate are arranged generally parallel to each other at the moment of a pattern being transferred from a patterned surface of the first roller to the substrate;
Fig. 4 is a cross-sectional side view of a nano-imprinting apparatus in accordance with an embodiment of the invention, where the nano-imprinting apparatus further includes a heating chamber and a cooling chamber;
Fig. 5 is a cross-sectional side view of a nano-imprinting apparatus in accordance with an embodiment of the invention, where the nano-imprinting apparatus further includes heating rollers and cooling rollers;
Fig. 6 is different view of the nano-imprinting apparatus of Fig. 5;
Fig. 7 is a cross-sectional view of an embodiment of the first and second rollers of the nano-imprinting apparatus shown in Figs. 5 and 6; and
Figs. 8-10 illustrate different embodiments of a nano-imprinting apparatus.

### Detailed Description of Embodiments

Embodiments of the present invention will be described more fully hereinafter with reference to the accompanying drawings, in which embodiments of the invention are shown. These embodiments are provided so that this disclosure will be thorough and complete, and will fully convey the scope of the invention to those skilled in the art. Like numbers refer to like elements throughout.

The present invention relates, in general, to a nano-imprinting apparatus and method for transferring a pattern from a template to a substrate. The present invention is based on a paradigm different from the prior art of nano-imprinting in that the template is in the form of a rotatably mounted roller to be brought into contact with the substrate to be patterned. Unlike current nano-imprinting apparatuses, some embodiments of the present invention are based on the utilization of two rotatably mounted rollers for transferring a pattern of micro or nanometer size to the substrate to be patterned.

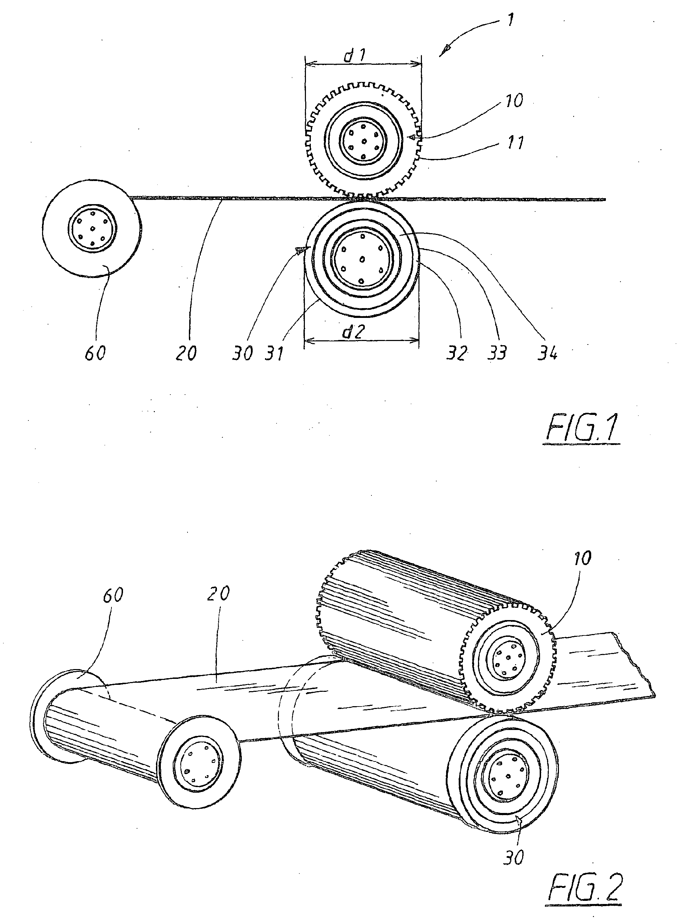

Figs. 1 and 2 schematically illustrate an embodiment of a nano-imprinting apparatus 1 according to the present invention. The function and the basic process step of the actual pattern transfer step, or imprint step, of an embodiment of the invention will now be described in connection with the nano-imprinting apparatus shown in Figs. 1 and 2.

The nano-imprinting apparatus 1 comprises a first rotatably mounted roller 10. The first rotatably mounted roller 10 has a patterned circumferential surface 11, in which three-dimensional protrusions and recesses are formed with a feature size in height and width within a range of 1 nm to several µm, and potentially both smaller and larger. The diameter d1 of the cylindrical roller 10 is typically between 1 decimeter and 5 meters. Preferably, the diameter d1 is within the range of 100-1000 millimeters. Furthermore, the length of the roller is typically between 1 decimeter and 5 meters. Preferably, the length of the roller 10 is within the range of 1-3 meters. Preferably, but not necessarily, the ratio between the diameter and the length of the rotatably roller is approximately 1:2. In a best mode as known to the inventor at the filing date of this application, the diameter d1 may be about 600 millimeters and the length about 1,5 meters.

The nano-imprinting apparatus 1 also comprises a second rotatably mounted roller 30. The second rotatably mounted roller 30 is rotatably coupled with the first rotatably mounted roller 10 such that synchronized rotation of the rollers 10, 30 is enabled. By synchronized rotation is meant that the speed of rotation of the first roller 10 is synchronized with that of the second roller 30. Furthermore, the second roller has a principally smooth circumferential surface 31. The diameter d2 of the second cylindrical roller 30 is typically between 1 decimeter and 5 meters. Preferably, the diameter d2 is within the range of 100-1000 millimeters. Furthermore, the length of the second roller is typically between 1 decimeter and 5 meters. Preferably, the diameter is within the range of 1-3 meters. Preferably, but not necessarily, the ratio between the diameter and length is approximately 1:2. In a best mode as known to the inventor at the filing date of this application, the diameter d2 may be about 600 millimeters and the length about 1,5 meters.

The axes of the respective rollers 10, 30 are positioned generally parallel to each other such that the respective surfaces 11, 31 face each other principally in a parallel fashion. Accordingly, the patterned circumferential surface of the first rotatably mounted roller and the principally smooth circumferential surface of the second rotatably mounted roller, which faces the patterned surface, are arranged such that these surfaces 11, 31 are generally parallel to each other when they are pressed towards each other.

A substrate 20 is moveable between the rollers 10, 30, when the rollers 10, 30 rotate with respect to each other. The substrate 20 is a deformable substrate 20, e.g. a substrate of a deformable material or a substrate covered by a deformable coating. The substrate preferably, but not necessarily, has a rectangular shape. The width of the substrate 20 is preferably chosen to correspond to the length of the respective rollers 10, 30. In the preferred and disclosed embodiment, the substrate is a continuous substrate 20. The continuous substrate 20 may be a thin film or a foil, e.g. a polymer foil. As used herein the term continuous substrate is used to mean a substrate with a length which is comparatively much larger than its width, as illustrated in the figures. The continuous substrate 20 may be fed between the rotatably mounted rollers 10, 30 from a feeding device 60. In the preferred and disclosed embodiment, the feeding device 60 is a reel for housing thin film rolls or foil rolls, e.g. polymer foil rolls.

During operation of the nano-imprinting apparatus 1, upon rotation of the rollers 10, 30 with respect to each other, the substrate 20 moves or passes between said rollers 10, 30 such that, when said rollers 10, 30 rotate with respect to each other, the patterned surface 11 of the first rotatably mounted roller 10 comes into contact with said substrate 20 whereby said pattern is transferred from the patterned surface 11 to the substrate 20. In order to accomplish a uniform imprint of the pattern to the substrate 20, the respective rollers 10,30 may advantageously be pressed towards each other. In other words, the first roller 10 may be pressed against the second roller 30, and vice versa. Either of or both of the first and the second rollers 10, 30 may be arranged to apply this pressure against the other roller 10, 30. The nano-imprinting apparatus 1 may comprise a means for controlling and regulating the applied pressure. It should preferably, but not necessarily, be possible to control and regulate the pressure either dynamically or statically. Furthermore, it should be possible to adjust the applied pressure at least within a range of 1-100 bar positive pressure. In order to accomplish a sufficiently uniform imprint of the pattern on the substrate 20, the applied pressure should preferably be within the range of 10-40 bar.

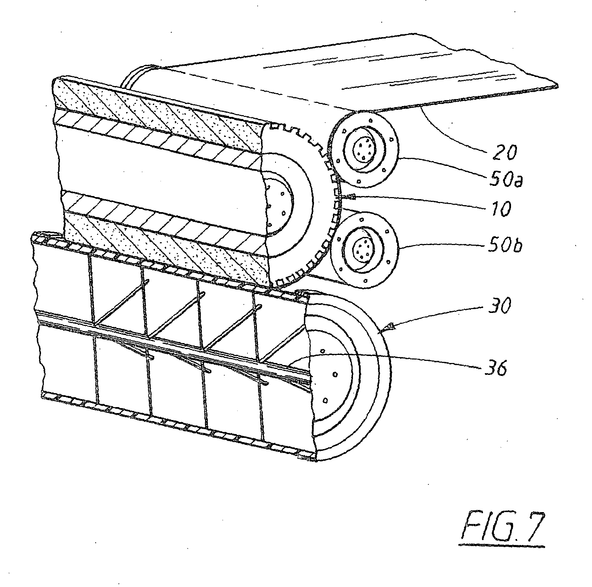

The second rotatably mounted roller 30 comprises a tubular-shaped cavity 32 for a medium having a certain pressure. As is illustrated in the figures, the second roller 30 comprises an inner cylinder 34. A membrane 33 is fit onto the inner cylinder 34 such that the membrane 33 is arranged around the circumferential surface of the inner cylinder 34. Accordingly, the geometric rotational axis of the tubular-shaped membrane 33 can be said to coincide with the rotational axis of the inner cylinder 34. The membrane 33 is typically made of a flexible material. Preferably, the material is a polymer material or a thin metal, even more preferably a plastic or a rubber. The membrane 33 has a thickness of about 1 mm. However, other dimensions are equally possible. As a best mode to the inventor as of the filing date of this application, the thickness of the membrane should be in the range of 1-10 mm. The membrane may be attached to the inner cylinder 34 in many conventionally known manners. As a mere example, the membrane 33 may be clamped to the inner cylinder 34 by clamp means 35 at the respective end sides of the second roller 30. The clamp means 35 is best shown in Fig. 7.

The cavity 32 is intended to accommodate a medium, preferably a gas (e.g. air, nitrogen or argon) which can be pressurized via an inlet channel. The inlet channel may be an inlet channel 36 as illustrated in Fig. 7. Thus, when the space between the inner cylinder 34 and the membrane 33 is filled by the medium, the tubular-shaped cavity 32 is formed. The actual dimension of the space between the inner cylinder 34 and the membrane 33 need not be large. Rather, it is sufficient that this space is in the order of micrometers such that the cavity 32 is capable of accommodating the medium. Pressurization of the medium accommodated in the cavity 32 may then take place e.g. by dynamic control which is adapted to provide pressure with very small variations. Alternatively, the pressure of the medium accommodated in the cavity 32 may be preset to a pre-defined pressure level. The pressure of the medium in the cavity can be increased/decreased via the inlet channel such that the pressure of said medium is in the range of 1-100 bar, preferably within the range of 10-40 bar. When the pressure of the medium in the cavity 32 is increased, the membrane 33 is arranged to flex out.

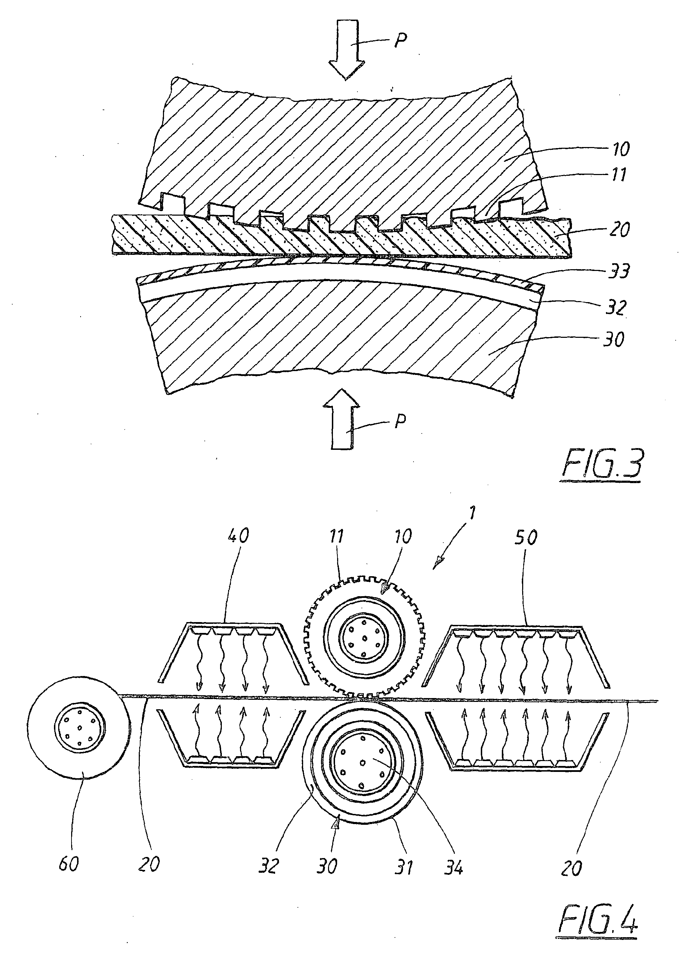

Again, during operation of the nano-imprinting apparatus 1, the respective rollers 10, 30 are pressed against each other while the substrate 20 moves there between. At the same time, the pressure of the medium in the cavity 32 can be controlled and/or regulated to increase/decrease. Thus, the total pressure between said rollers 10, 30 may be a combined pressure of i) the pressure applied by the rollers 10, 30 against each other and ii) the pressure applied by means of the pressurized gas accommodated in the cavity 32. When the pressure of the medium in the cavity 32 is increased, the membrane 33 flexes out such that the membrane 33 presses the substrate 20 towards the patterned surface 11 of the first roller 10. Thanks to the pressure from the cavity 32 via the flexible membrane 33, an even distribution of force is obtained over the whole of the contact surface between the substrate 20 and the patterned surface 11 of the first roller 10 when the membrane 33 is flexed out due to the pressure of the medium. This is made to arrange roller 10, substrate 20, and roller 30 generally parallel in relation to one another when viewed at a micro or nano level, as is illustratively shown in Fig. 3.

Fig. 3 illustrates a cross-section of a portion of the substrate 20, on a micro or nano size level, when the patterned surface 11 of the first rotatably mounted roller 10 comes into contact with the substrate 20. As is illustrated in Fig. 3, the substrate 20 has an upper surface which is arranged substantially or almost parallel to patterned surface 11 of the template, i.e. the first rotatably mounted roller 10, in the moment of contact between the patterned surface 11 and the upper surface of the substrate 20. Furthermore, the membrane 33 (which forms the surface 31 of the second roller 30) is arranged substantially or almost parallel to the lower surface of the substrate 20. This way, the membrane 33 may act as a generally parallel support member for pressing against the lower surface of the substrate 20 during the imprint of the micro or nano size pattern from the patterned surface 11 of the first roller 10 to the upper surface of the substrate 20.

Since the first roller 10, substrate 20, and second roller 30 are sufficiently parallel in relation to one another (on a micro or nano level) the influence of irregularities in the upper surface of the substrate 20 or on the patterned surface 11 of the first roller 10 may be reduced or even eliminated. Furthermore, the pressure from the cavity 32 via the flexible membrane 33 which acts towards the lower surface of the substrate 20 during imprint may allow for a comfortable imprint of the micro or nano size pattern from the patterned surface 11 into the deformable substrate 20. Furthermore, it has turned out that the pressure of the medium of the cavity 32 may allow for flexing out the flexible membrane 33 such that an imprinting step involves only very little or no sliding effect between the respective rollers 10, 30 and the substrate 20. For avoiding any potential sliding effect it may also be important that the respective rollers 10, 30 are rotatably coupled with respective to each other such that synchronized rotation is enabled.

Figs. 4-6 illustrate various advantageous embodiments of the nano-imprinting apparatus 1 shown in Figs. 1, 2 and 3, where the nano-imprinting apparatus 1 further includes a heating means 40 and a cooling means 50.

In the embodiment shown in Fig. 4, the heating means 40 is a heating chamber positioned to heat the substrate 20 before said substrate moves between said first and second rollers 10, 30. Accordingly, at least the upper layer of deformable substrate 20 can be softened prior to the subsequent imprinting of the micro or nano size pattern from patterned surface 11 of the first roller 10 to the substrate when said rollers 10, 30 rotate with respect to each other and the patterned surface 11 of the first rotatably mounted roller 10 comes into contact with the substrate 20. Inside heating chamber 40, one or more heaters circulate hot air preferably within the range of 100-200°C, and even more preferably within the range of 150-170 °C. Also, the cooling means 50 is a cooling chamber positioned to cool down the substrate 20 after the substrate 20 has passed between said first and second rollers 10, 30 during the imprint step. Accordingly, after the imprinting of the pattern from the patterned surface 11 to the substrate 20, the substrate is cooled down until it hardens to a satisfactory degree. Inside cooling chamber 50, one or more coolers are positioned for lowering the temperature of the substrate 20 so that the substrate is cooled down until it hardens to a satisfactory degree. For cooling down the temperature of the substrate 20, the coolers may be arranged to circulate water or air with a temperature of 130 °C or lower within the cooling chamber 50.

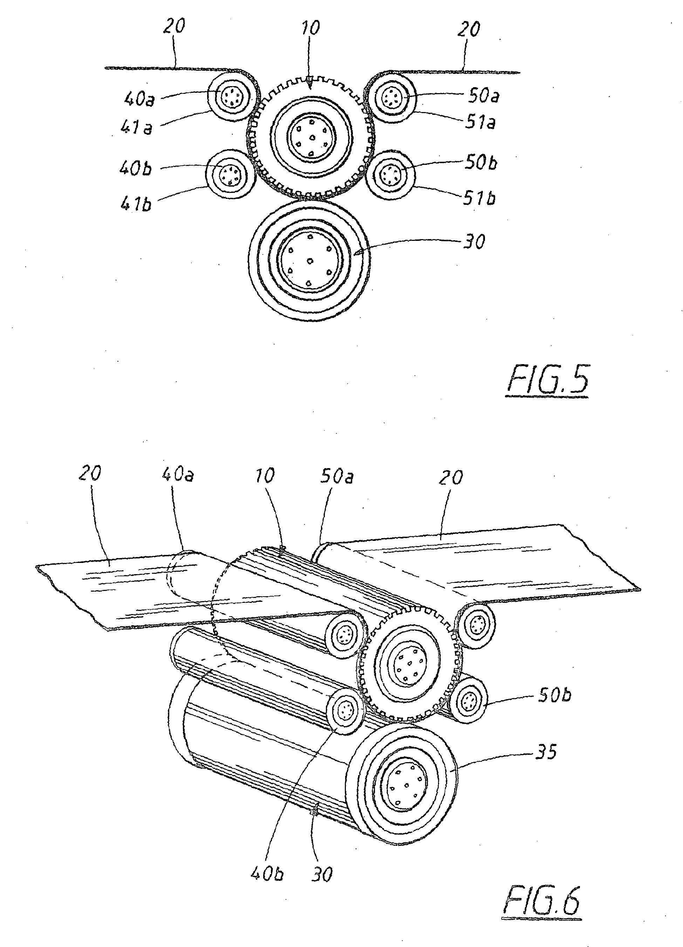

Figs. 5 and 6 illustrate a preferred embodiment of the invention. In the embodiment shown in Figs. 5 and 6, the heating means 40 comprises one or more, preferably two, heating rollers positioned to heat the substrate 20. Also, the cooling means 50 comprises one or more, preferably two, cooling rollers positioned to cool down the substrate. In the disclosed and preferred embodiment, two heating rollers 40a, 40b and two cooling rollers 50a, 50b, respectively, are utilized for heating/cooling of the substrate 20.

The nano-imprinting apparatus 1 of Figs. 5 and 6 comprises two rotatably mounted heating rollers 40a, 40b, each with a principally plane circumferential and heated surface 41a, 41b and means for adjusting a temperature of said surface to a temperature within the range of 100-200°C, preferably within the range of 150-170 °C. The heating rollers 40a, 40b are rotatably coupled with the first rotatably mounted roller 10 for synchronized rotation of the heating rollers 40a, 40b and the first roller 10. Consequently, during operation when the heating rollers 40a, 40b and the first and second rollers 10, 30 rotate with respect to each other, the substrate 20 can come into contact with the heated surface 41a, 41b. The heating rollers 40a, 40b may be positioned as illustrated in Figs. 5 and 6. Hence, during operation, heating of the substrate 20 is performed before said substrate moves between said first and second rollers 10, 30. Moreover, the nano-imprinting apparatus 1 of Figs. 5 and 6 comprises two rotatably mounted cooling rollers 50, 50b, each with a principally plane circumferential and cooling surface 51a, 51b and means for adjusting a temperature of said surface to a temperature within the range of 130 °C and below. The cooling rollers 50a, 50b are rotatably coupled with the first rotatably mounted roller 10 for synchronized rotation of the cooling rollers 50a, 50b and the first roller 10. Thus, during operation when the cooling rollers 50a, 50b and the first and second rollers 10, 30 rotate with respect to each other, the substrate 20 can come into contact with the cooling surfaces 51a, 51b such that substrate 20 is cooled down until it hardens to a satisfactory degree.

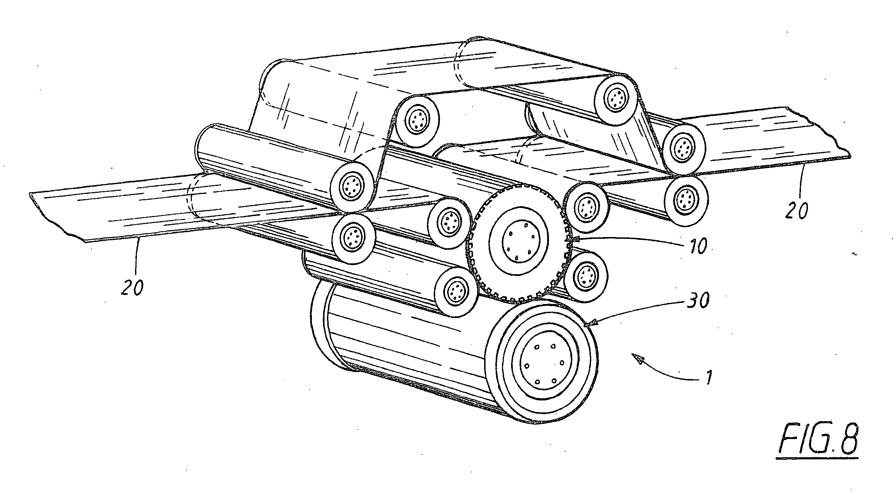

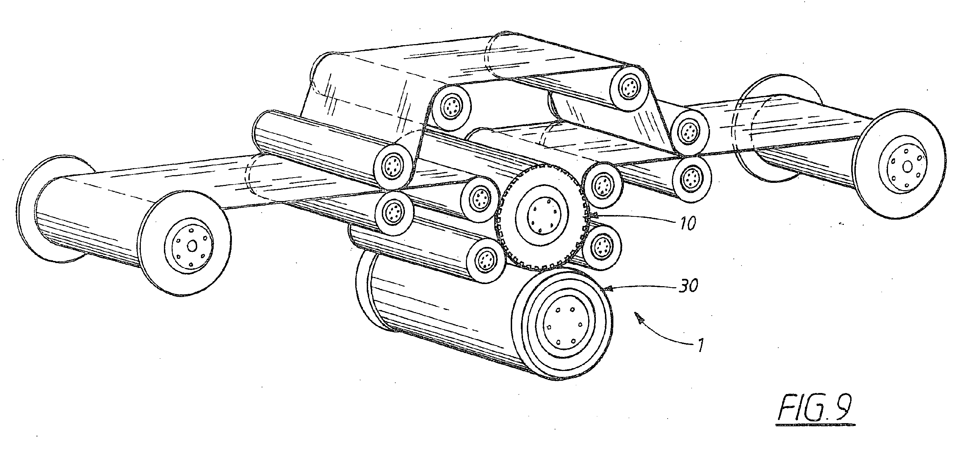

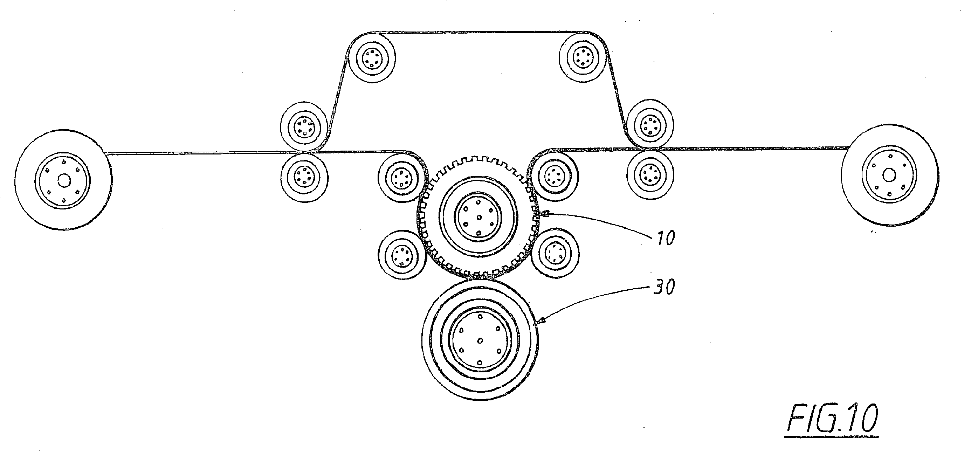

Figs. 8 to 10 disclose further arrangements or embodiments of a nano-imprinting apparatus 1, which are based on the utilization of rotatably mounted rollers for transferring a pattern of micro or nanometer size to the substrate to be patterned.

Some embodiments of the nano-imprinting apparatus and method according to this invention are particularly advantageous for large area imprint in a single imprint step and have as such huge benefits over previously known techniques for nano-imprint lithography on large area substrates or objects. Thanks to the two rotatably mounted rollers, large area substrates or objects may be in the form of continuous substrates, e.g. thin films or polymer foils, which can move between the two rotatably rollers upon rotation of the rollers. This may allow for a continuous process with high throughput capacity for producing fabrication of structures comprising three-dimensional features on a micro or nanometer scale. Some embodiments of the present invention can be used for transferring a micro or nano size pattern to large-area substrates with total areas of 400x600 mm and larger. For example, full flat panel displays with sizes of about 400x600 mm and larger can thus be patterned with a single imprint in accordance with some embodiments of the invention. Some embodiments of the present invention therefore offers a nano-imprinting apparatus and method which is interesting for large-scale production of fine structure devices on large area substrates or objects, e.g. in applications such as full flat panel displays.

The principles of the present invention have been described in the foregoing by examples of embodiments or modes of operations. However, the invention is defined by the appended claims.

## Claims

1. A nano-imprinting apparatus (1), comprising:
a first rotatably mounted roller (10) having a patterned circumferential surface (11) for transferring a pattern from the first rotatably mounted roller (10) to a deformable substrate (20) by contacting said patterned surface (11) with said substrate (20);
a second rotatably mounted roller (30) having a principally smooth circumferential surface (31) which faces the patterned surface (11) of the first rotatably mounted roller (10), the second rotatably mounted roller (30) being rotatably coupled with the first rotatably mounted roller (10) for synchronized rotation of said rollers (10,30);
the substrate (20) is movable between said rollers (10,30) such that, when said rollers (10, 30) rotate with respect to each other, the patterned surface (11) of the first rotatably mounted roller (10) comes into contact with said substrate (20) whereby said pattern is transferred from the patterned surface (11) to the substrate (20),
**characterised in that**
the second rotatably mounted roller (30) comprises a tubular shaped cavity (32) for a medium having a certain pressure, a wall of said cavity (32) consisting of a membrane (33) of which one side, which faces away from the cavity (32), forms said principally smooth circumferential surface (31).

2. A nano-imprinting apparatus (1) according to claim 1, wherein at least one of the first and the second roller (10,30) is arranged to apply a pressure against the other roller (10, 30) when said rollers (10, 30) rotate with respect to each other.

3. A nano-imprinting apparatus (1) according to claim 2, wherein the mentioned pressure is within the range of 1-100 bar positive pressure, preferably within the range of 10-40 bar positive pressure.

4. A nano-imprinting apparatus (1) according to claim 1, further comprising means for adjusting the pressure of said medium to a pressure within a range of 1-100 bar positive pressure, preferably within a range of 1-40 bar.

5. A nano-imprinting apparatus according to claim 1 or 4, wherein the membrane (33) is made of a flexible material, preferably a polymer material or a thin metal, even more preferably a plastic, a rubber or a thin metal, the membrane (33) having a thickness of up to 10 mm, preferably up to 3 mm or even more preferably up to 1 mm.

6. A nano-imprinting apparatus according to any of the claims 4-5, wherein the medium comprises a gas.

7. A nano-imprinting apparatus according to claim 6, wherein said medium comprises air.

8. A nano-imprinting apparatus according to any of the preceding claims, wherein the first rotatably mounted roller (10) has a diameter of up to 5 m, preferably up to 2 m, and even more preferably up to 1 m.

9. A nano-imprinting apparatus according to claim 8, wherein the first rotatably mounted roller (10) has a length of up to 2,5 m, preferably up to 1.5 m, and even more preferably up to 1 m.

10. A nano-imprinting apparatus according to claim 9, wherein the ratio between the diameter and the length of the first rotatably mounted roller (10) is 1:2.

11. A nano-imprinting apparatus according to any of the preceding claims, wherein the second rotatably mounted roller (30) has a diameter of up to 5 m, preferably up to 2 m, and even more preferably up to 1 m.

12. A nano-imprinting apparatus according to claim 11, wherein the second rotatably mounted roller (30) has a length of up to 2,5 m, preferably up to 1.5 m, and even more preferably up to 1 m.

13. A nano-imprinting apparatus according to claim 12, wherein the ratio between the diameter and the length of the second rotatably mounted roller (30) is 1:2.

14. A nano-imprinting apparatus according to any of the preceding claims, further comprising a heating means (40) for heating the substrate (20), wherein the heating means is positioned to heat the substrate (20) before said substrate moves between said first and second rollers (10, 30).

15. A nano-imprinting apparatus according to claim 14, wherein the heating means is a heating chamber positioned such that the substrate (20) is moveable through said heating chamber such that, during operation, heating of the substrate (20) is performed before said substrate moves between said first and second rollers (10, 30).

16. A nano-imprinting apparatus according to claim 14, wherein the heating means comprises at least one further rotatably mounted roller (40a, 40b) with a principally plane circumferential and heated surface (41a, 41b) positioned such that the substrate (20) is moveable onto said heated surface (41 a, 41b) such that, during operation, heating of the substrate (20) is performed via said heated surface (41a, 41 b) before said substrate moves between said first and second rollers (10,30).

17. A nano-imprinting apparatus according to any of the preceding claims, further comprising a cooling means (50) for cooling the substrate (20), wherein the cooling means (50) is positioned to cool the substrate (20) after said substrate has passed between said first and second rollers (10, 30).

18. A nano-imprinting apparatus according to claim 17, wherein the cooling means (50) is a cooling chamber positioned such that the substrate (20) is moveable through said cooling chamber such that, during operation, cooling of the substrate (20) is performed after said substrate has passed between said first and second rollers (10, 30).

19. A nano-imprinting apparatus according to claim 17, wherein the cooling means (50) comprises at least one further rotatably mounted roller (50a, 50b) with a principally plane circumferential and cooling surface (5 1 a, 51b) positioned such that the substrate (20) is moveable onto said cooling surface (51 a, 51b) such that, during operation, cooling of the substrate (20) is performed via said cooling surface (51a, 51b) after said substrate has moved between said first and second rollers (10, 30).

20. A nano-imprinting apparatus according to any of the preceding claims, wherein the substrate is a continuous substrate.

21. A nano-imprinting apparatus according to claim 20, wherein the substrate is a foil or a thin film.

22. A nano-imprinting method performed by an apparatus having a first rotatably mounted roller with a patterned circumferential surface for transferring a pattern from the first rotatably mounted roller to a deformable substrate by contacting said patterned surface with said substrate, and a second rotatably mounted roller with a principally smooth circumferential surface which faces the patterned surface of the first rotatably mounted roller, the second rotatably mounted roller being rotatably coupled with the first rotatably mounted roller for synchronized rotation of said rollers, the method comprising the steps of:
rotating said rollers with respect to each other; and
moving the substrate between said rollers such that, when said rollers rotate with respect to each other, the patterned surface of the first rotatably mounted roller comes into contact with said substrate whereby said pattern is transferred from the patterned surface to the substrate, **characterised in that**
the second rotatably mounted roller comprises a tubular-shaped cavity for a medium having a certain pressure, a wall of said cavity consisting of a membrane of which one side, which faces away from the cavity, forms said principally smooth circumferential surface, the method further comprising the step of
adjusting the pressure of said medium to a pressure within a range of 1- 100 bar positive pressure, preferably within a range of 10-40 bar.

23. A nano-imprinting method according to claim 22, further comprising the step of
applying a pressure against either of or both of said rollers when said rollers rotate with respect to each other.

24. A nano-imprinting method according to claim 22, wherein the medium comprises a gas.

25. A nano-imprinting method according to claim 24, wherein the medium comprises air.

26. A nano-imprinting method according to any of the claims 22-25, further comprising the step of: heating the substrate before said substrate moves between said first and second rollers.

27. A nano-imprinting method according to any of the claims 22-27, further comprising the step of: cooling the substrate after said substrate has passed between said first and second rollers.

28. A nano-imprinting method according to any of the claims 22-27, wherein the substrate is a continuous substrate.

29. A nano-imprinting method according to claim 28, wherein the substrate is a foil or a thin film.

## Patentansprüche

1. Nanoimprint-Vorrichtung (1), umfassend:
eine erste drehbar angebrachte Walze (10), die eine strukturierte Umfangsfläche (11) aufweist, zum Übertragen einer Struktur von der ersten drehbar angebrachten Walze (10) auf ein deformierbares Substrat (20) durch Kontaktieren der strukturierten Fläche (11) mit dem Substrat (20);
eine zweite drehbar angebrachte Walze (30), die eine im Wesentlichen glatte Umfangsfläche (31) aufweist, die der strukturierten Fläche (11) der ersten drehbar angebrachten Walze (10) gegenübersteht, wobei die zweite drehbar angebrachte Walze (30) drehbar mit der ersten drehbar angebrachten Walze (10) zur synchronisierten Drehung der Walzen (10, 30) gekoppelt ist;
wobei das Substrat (20) beweglich zwischen den Walzen (10, 30) ist, derart, dass dann, wenn sich die Walzen (10, 30) in Bezug aufeinander drehen, die strukturierte Fläche (11) der ersten drehbar angebrachten Walze (10) in Kontakt mit dem Substrat (20) kommt, wodurch die Struktur von der strukturierten Fläche (11) auf das Substrat (20) übertragen wird,
**dadurch gekennzeichnet, dass**
die zweite drehbar angebrachte Walze (30) einen röhrenförmig geformten Hohlraum (32) für ein Medium umfasst, das einen bestimmten Druck aufweist, wobei eine Wand des Hohlraums (32) aus einer Membran (33) besteht, deren eine Seite, die weg von dem Hohlraum (32) weist, die im Wesentlichen glatte Umfangsfläche (31) bildet.

2. Nanoimprint-Vorrichtung (1) nach Anspruch 1, wobei zumindest eine der ersten und zweiten Walzen (10, 30) angeordnet ist, einen Druck auf die andere Walze (10, 30) auszuüben, wenn sich die Walzen (10, 30) in Bezug aufeinander drehen.

3. Nanoimprint-Vorrichtung (1) nach Anspruch 2, wobei der erwähnte Druck innerhalb des Bereichs von 1-100 bar positiven Drucks, vorzugsweise innerhalb des Bereichs von 10-40 bar positiven Drucks ist.

4. Nanoimprint-Vorrichtung (1) nach Anspruch 1, ferner umfassend eine Einrichtung zum Einstellen des Drucks des Mediums auf einen Druck innerhalb eines Bereichs von 1-100 bar positiven Drucks, vorzugweise innerhalb eines Bereichs von 1-40 bar positiven Drucks.

5. Nanoimprint-Vorrichtung (1) nach Anspruch 1 oder 4, wobei die Membran (33) aus einem flexiblen Material ausgeführt ist, vorzugsweise einem Polymermaterial oder einem dünnen Metall, in noch bevorzugterer Weise aus einem Kunststoff, einem Gummi oder einem dünnen Metall, wobei die Membran (33) eine Dicke von bis zu 10 mm, vorzugsweise bis zu 3 mm, oder in noch bevorzugterer Weise bis zu 1 mm aufweist.

6. Nanoimprint-Vorrichtung nach einem der Ansprüche 4 oder 5, wobei das Medium ein Gas umfasst.

7. Nanoimprint-Vorrichtung nach Anspruch 6, wobei das Medium Luft umfasst.

8. Nanoimprint-Vorrichtung nach einem der voranstehenden Ansprüche, wobei die erste drehbar angebrachte Walze (10) einen Durchmesser von bis zu 5 m, vorzugsweise bis zu 2 m, und in noch bevorzugterer Weise bis zu 1 m aufweist.

9. Nanoimprint-Vorrichtung nach Anspruch 8, wobei die erste drehbar angebrachte Walze (10) eine Länge von bis zu 2,5 m, vorzugsweise bis zu 1,5 m, und in noch bevorzugterer Weise von bis zu 1 m aufweist.

10. Nanoimprint-Vorrichtung nach Anspruch 9, wobei das Verhältnis zwischen dem Durchmesser und der Länge der ersten drehbar angebrachten Walze (10) 1:2 ist.

11. Nanoimprint-Vorrichtung nach einem der voranstehenden Ansprüche, wobei die zweite drehbar angebrachte Walze (30) einen Durchmesser von bis zu 5 m, vorzugsweise bis zu 2 m, und in noch bevorzugterer Weise bis zu 1 m aufweist.

12. Nanoimprint-Vorrichtung nach Anspruch 11, wobei die zweite drehbar angebrachte Walze (30) eine Länge von bis zu 2,5 m, vorzugsweise bis zu 1,5 m und in noch bevorzugterer Weise bis zu 1 m aufweist.

13. Nanoimprint-Vorrichtung nach Anspruch 12, wobei das Verhältnis zwischen dem Durchmesser und der Länge der zweiten drehbar angebrachten Walze (30) 1:2 ist.

14. Nanoimprint-Vorrichtung nach einem der voranstehenden Ansprüche, ferner umfassend eine Heizeinrichtung (40) zum Erwärmen des Substrats (20), wobei die Heizeinrichtung positioniert ist, das Substrat (20) zu erwärmen, bevor sich das Substrat zwischen die ersten und zweiten Walzen (10, 30) bewegt.

15. Nanoimprint-Vorrichtung nach Anspruch 14, wobei die Heizeinrichtung eine Heizkammer ist, die derart positioniert ist, dass das Substrat (20) derart durch die Heizkammer beweglich ist, dass während des Betriebs ein Erwärmen des Substrats (20) durchgeführt wird, bevor sich das Substrat zwischen die ersten und zweiten Walzen (10, 30) bewegt.

16. Nanoimprint-Vorrichtung nach Anspruch 14, wobei die Heizeinrichtung zumindest eine weitere drehbar angebrachte Walze (40a 40b) mit einer im Wesentlichen ebenen Umfangs- und erwärmten Fläche (41 a, 41 b) umfasst, die derart positioniert ist, dass das Substrat (20) auf die erwärmte Fläche (41 a, 41 b) beweglich ist, derart, dass während eines Betriebs ein Erwärmen des Substrats (20) über die erwärmte Fläche (41 a, 41 b) durchgeführt wird, bevor sich das Substrat zwischen die ersten und zweiten Walzen (10, 30) bewegt.

17. Nanoimprint-Vorrichtung nach einem der voranstehenden Ansprüche, ferner umfassend eine Kühleinrichtung (50) zum Kühlen des Substrats, wobei die Kühleinrichtung (50) positioniert ist, das Substrat (20) zu kühlen, nachdem das Substrat zwischen den ersten und zweiten Walzen (10 ,30) durchgelaufen ist,

18. Nanoimprint-Vorrichtung nach Anspruch 17, wobei die Kühleinrichtung (50) eine Kühlkammer ist, die derart positioniert ist, dass das Substrat durch die Kühlkammer beweglich ist, derart, dass während eines Betriebs ein Kühlen des Substrats (20) durchgeführt wird, nachdem das Substrat zwischen den ersten und zweiten Walzen (10, 30) durchgelaufen ist.

19. Nanoimprint-Vorrichtung nach Anspruch 17, wobei die Kühleinrichtung (50) zumindest eine weitere drehbar angebrachte Walze (50a, 50b) mit einer im Wesentlichen ebenen Umfangs- und Kühlfläche (51 a, 51 b) umfasst, die derart positioniert ist, dass während eines Betriebs ein Kühlen des Substrats (20) über die Kühlfläche (51 a, 51 b) durchgeführt wird, nachdem sich das Substrat zwischen den ersten und zweiten Walzen (10, 30) bewegt hat.

20. Nanoimprint-Vorrichtung nach einem der voranstehenden Ansprüche, wobei das Substrat ein kontinuierliches Substrat ist.

21. Nanoimprint-Vorrichtung nach Anspruch 20, wobei das Substrat eine Folie oder ein Dünnfilm ist.

22. Nanoimprint-Verfahren, durchgeführt mit einer Vorrichtung, die eine erste drehbar angebrachte Walze mit einer strukturierten Umfangsfläche zum Übertragen einer Struktur von der ersten drehbar angebrachten Walze auf ein deformierbares Substrat durch Kontaktieren der strukturierten Fläche mit dem Substrat und eine zweite drehbar angebrachte Walze mit einer im Wesentlichen glatten Umfangsfläche aufweist, die der strukturierten Fläche der ersten drehbar angebrachten Walze gegenübersteht, wobei die zweite drehbar angebrachte Walze drehbar mit der ersten drehbar angebrachten Walze zur synchronisierten Drehung der Walzen gekoppelt ist, wobei das Verfahren die Schritte umfasst:
Drehen der Walzen in Bezug aufeinander; und
Bewegen des Substrats zwischen die Walzen derart, dass dann, wenn sich die Walzen in Bezug aufeinander drehen, die strukturierte Fläche der ersten drehbar angebrachten Walze in Kontakt mit dem Substrat kommt, wodurch die Struktur von der strukturierten Fläche auf das Substrat übertragen wird,
**dadurch gekennzeichnet, dass**
die zweite drehbar angebrachte Walze einen röhrenförmig geformten Hohlraum für ein Medium umfasst, das einen bestimmten Druck aufweist, wobei eine Wand des Hohlraums aus einer Membran besteht, deren eine Seite, die weg von dem Hohlraum weist, die im Wesentlichen glatte Umfangsfläche bildet, wobei das Verfahren ferner den Schritt umfasst:
Einstellen des Drucks des Mediums auf einen Druck innerhalb eines Bereichs von 1-100 bar positiven Drucks, vorzugsweise innerhalb eines Bereichs von 10-40 bar.

23. Nanoimprint-Verfahren nach Anspruch 22, ferner umfassend den Schritt:
Aufbringen eines Drucks auf entweder eine oder beide Walzen, wenn sich die Walzen in Bezug aufeinander drehen.

24. Nanoimprint-Verfahren nach Anspruch 22, wobei das Medium ein Gas umfasst.

25. Nanoimprint-Verfahren nach Anspruch 24, wobei das Medium Luft umfasst.

26. Nanoimprint-Verfahren nach einem der Ansprüche 22-25, ferner umfassend den Schritt: Erwärmen des Substrats, bevor sich das Substrat zwischen die ersten und zweiten Walzen bewegt.

27. Nanoimprint-Verfahren nach einem der Ansprüche 22-27, ferner umfassend den Schritt: Kühlen des Substrats, nachdem das Substrat zwischen den ersten und zweiten Walzen durchgelaufen ist.

28. Nanoimprint-Verfahren nach einem der Ansprüche 22-27, wobei das Substrat ein kontinuierliches Substrat ist.

29. Nanoimprint-Verfahren nach Anspruch 28, wobei das Substrat eine Folie oder ein Dünnfilm ist.

## Revendications

1. Appareil de nano-impression (1), comprenant :
un premier rouleau monté en rotation (10) qui possède une surface circonférentielle dotée d'un motif (11) pour transférer un motif du premier rouleau monté en rotation (10) à un substrat déformable (20) en mettant ladite surface dotée d'un motif (11) en contact avec ledit substrat (20) ;
un deuxième rouleau monté en rotation (30) qui possède une surface circonférentielle pratiquement lisse (31) qui fait face à la surface dotée d'un motif (11) du premier rouleau monté en rotation (10), le deuxième rouleau monté en rotation (30) étant couplé en rotation avec le premier rouleau monté en rotation (10) de façon à permettre une rotation synchronisée desdits rouleaux (10, 30) ;
le substrat (20) peut se déplacer entre lesdits rouleaux (10, 30) de telle façon que, lorsque lesdits rouleaux (10, 30) tournent l'un par rapport à l'autre, la surface dotée d'un motif (11) du premier rouleau monté en rotation (10) vient en contact avec ledit substrat (20), ledit motif étant ainsi transféré de la surface dotée d'un motif (11) au substrat (20),
**caractérisé en ce que** le deuxième rouleau monté en rotation (30) comprend une cavité de forme tubulaire (32) destinée à recevoir un fluide ayant une certaine pression, une paroi de ladite cavité (32) étant constituée d'une membrane (33) dont un côté situé à l'opposé de la cavité (32) forme ladite surface circonférentielle pratiquement lisse (31).

2. Appareil de nano-impression (1) selon la revendication 1, dans lequel l'un au moins du premier et du deuxième rouleau (10, 30) est disposé de façon à appliquer une pression contre l'autre rouleau (10, 30) lorsque lesdits rouleaux (10, 30) tournent l'un par rapport à l'autre.

3. Appareil de nano-impression (1) selon la revendication 2, dans lequel la pression en question se situe dans la plage de 1 à 100 bar de pression positive, de préférence dans la plage de 10 à 40 bar de pression positive.

4. Appareil de nano-impression (1) selon la revendication 1, comprenant en outre un moyen pour ajuster la pression dudit fluide à une valeur dans la plage de 1 à 100 bar de pression positive, de préférence dans la plage de 1 à 40 bar.

5. Appareil de nano-impression selon la revendication 1 ou la revendication 4, dans lequel la membrane (33) est faite d'un matériau flexible, de préférence un matériau polymère ou un métal mince, plus préférentiellement encore un plastique, un caoutchouc ou un métal mince, la membrane (33) ayant une épaisseur qui peut aller jusqu'à 10 mm, de préférence jusqu'à 3 mm ou plus préférentiellement encore jusqu'à 1 mm.

6. Appareil de nano-impression selon l'une quelconque des revendications 4 à 5, dans lequel le fluide comprend un gaz.

7. Appareil de nano-impression selon la revendication 6, dans lequel ledit fluide comprend de l'air.

8. Appareil de nano-impression selon l'une quelconque des revendications précédentes, dans lequel le premier rouleau monté en rotation (10) a un diamètre qui peut aller jusqu'à 5 m, de préférence jusqu'à 2 m et plus préférentiellement encore jusqu'à 1 m.

9. Appareil de nano-impression selon la revendication 8, dans lequel le premier rouleau monté en rotation (10) a une longueur qui peut aller jusqu'à 2,5 m, de préférence jusqu'à 1,5 m et plus préférentiellement encore jusqu'à 1 m.

10. Appareil de nano-impression selon la revendication 9, dans lequel le rapport entre le diamètre et la longueur du premier rouleau monté en rotation (10) est égal à 1:2.

11. Appareil de nano-impression selon l'une quelconque des revendications précédentes, dans lequel le deuxième rouleau monté en rotation (30) a un diamètre qui peut aller jusqu'à 5 m, de préférence jusqu'à 2 m et plus préférentiellement encore jusqu'à 1 m.

12. Appareil de nano-impression selon la revendication 11, dans lequel le deuxième rouleau monté en rotation (30) a une longueur qui peut aller jusqu'à 2,5 m, de préférence jusqu'à 1,5 m et plus préférentiellement encore jusqu'à 1 m.

13. Appareil de nano-impression selon la revendication 12, dans lequel le rapport entre le diamètre et la longueur du deuxième rouleau monté en rotation (30) est égal à 1:2.

14. Appareil de nano-impression selon l'une quelconque des revendications précédentes, comprenant en outre un moyen de chauffage (40) pour chauffer le substrat (20), ledit moyen de chauffage étant positionné de façon à chauffer le substrat (20) avant que ledit substrat se déplace entre lesdits premier et deuxième rouleaux (10, 30).

15. Appareil de nano-impression selon la revendication 14, dans lequel le moyen de chauffage est une chambre chauffante positionnée de telle façon que le substrat (20) peut traverser ladite chambre chauffante de telle façon que, en fonctionnement, le chauffage du substrat (20) se fait avant que ledit substrat se déplace entre lesdits premier et deuxième rouleaux (10, 30).

16. Appareil de nano-impression selon la revendication 14, dans lequel le moyen de chauffage comprend au moins un autre rouleau monté en rotation (40a, 40b), ayant une surface circonférentielle pratiquement plane et chauffée (41 a, 41 b) et positionné de telle façon que le substrat (20) peut se déplacer sur ladite surface chauffée (41 a, 41 b) de telle façon que, en fonctionnement, le chauffage du substrat (20) se fait par l'intermédiaire de ladite surface chauffée (41 a, 41 b) avant que ledit substrat se déplace entre lesdits premier et deuxième rouleaux (10, 30).

17. Appareil de nano-impression selon l'une quelconque des revendications précédentes, comprenant en outre un moyen de refroidissement (50) pour refroidir le substrat (20), ledit moyen de refroidissement (50) étant positionné de façon à refroidir le substrat (20) après que ledit substrat est passé entre lesdits premier et deuxième rouleaux (10, 30).

18. Appareil de nano-impression selon la revendication 17, dans lequel le moyen de refroidissement (50) est une chambre refroidissante positionnée de telle façon que le substrat (20) peut traverser ladite chambre refroidissante de telle façon que, en fonctionnement, le refroidissement du substrat (20) se fait après que ledit substrat est passé entre lesdits premier et deuxième rouleaux (10, 30).

19. Appareil de nano-impression selon la revendication 17, dans lequel le moyen de refroidissement (50) comprend au moins un autre rouleau monté en rotation (50a, 50b), ayant une surface circonférentielle pratiquement plane et refroidissante (51 a, 51 b) et positionné de telle façon que le substrat (20) peut se déplacer sur ladite surface refroidissante (51 a, 51 b) de telle façon que, en fonctionnement, le refroidissement du substrat (20) se fait par l'intermédiaire de ladite surface refroidissante (51 a, 51 b) après que ledit substrat est passé entre lesdits premier et deuxième rouleaux (10, 30).

20. Appareil de nano-impression selon l'une quelconque des revendications précédentes, dans lequel le substrat est un substrat continu.

21. Appareil de nano-impression selon la revendication 20, dans lequel le substrat est une feuille ou un film mince.

22. Procédé de nano-impression réalisé par un appareil qui comprend un premier rouleau, monté en rotation et ayant une surface circonférentielle dotée d'un motif pour transférer un motif du premier rouleau monté en rotation à un substrat déformable en mettant ladite surface dotée d'un motif en contact avec ledit substrat, et un deuxième rouleau, monté en rotation et ayant une surface circonférentielle pratiquement lisse qui fait face à la surface dotée d'un motif du premier rouleau monté en rotation, le deuxième rouleau monté en rotation étant couplé en rotation avec le premier rouleau monté en rotation de façon à permettre une rotation synchronisée desdits rouleaux, le procédé comprenant les étapes consistant à :
faire tourner lesdits rouleaux l'un par rapport à l'autre ; et
déplacer le substrat entre lesdits rouleaux de telle façon que, lorsque lesdits rouleaux tournent l'un par rapport à l'autre, la surface dotée d'un motif du premier rouleau monté en rotation vient en contact avec ledit substrat, ledit motif étant ainsi transféré de la surface dotée d'un motif au substrat,
**caractérisé en ce que**
le deuxième rouleau monté en rotation comprend une cavité de forme tubulaire destinée à recevoir un fluide ayant une certaine pression, une paroi de ladite cavité étant constituée d'une membrane dont un côté situé à l'opposé de la cavité forme ladite surface circonférentielle pratiquement lisse, le procédé comprenant en outre l'étape consistant à :
ajuster la pression dudit fluide à une valeur dans la plage de 1 à 100 bar de pression positive, de préférence dans la plage de 10 à 40 bar.

23. Procédé de nano-impression selon la revendication 22, comprenant en outre l'étape consistant à :
appliquer une pression contre l'un ou l'autre desdits rouleaux, ou les deux, lorsque lesdits rouleaux tournent l'un par rapport à l'autre.

24. Procédé de nano-impression selon la revendication 22, dans lequel le fluide comprend un gaz.

25. Procédé de nano-impression selon la revendication 24, dans lequel le fluide comprend de l'air.

26. Procédé de nano-impression selon l'une quelconque des revendications 22 à 25, comprenant en outre l'étape consistant à :
chauffer le substrat avant que ledit substrat se déplace entre lesdits premier et deuxième rouleaux.

27. Procédé de nano-impression selon l'une quelconque des revendications 22 à 27, comprenant en outre l'étape consistant à :
refroidir le substrat après le ledit substrat est passé entre lesdits premier et deuxième rouleaux.

28. Procédé de nano-impression selon l'une quelconque des revendications 22 à 27, dans lequel le substrat est un substrat continu.

29. Procédé de nano-impression selon la revendication 28, dans lequel le substrat est une feuille ou un film mince.
